# EUROPEAN PATENT SPECIFICATION

(11) **EP 3 499 556 B1**
(45) Date of publication and mention of the grant of the patent: **07.04.2021**
(21) Application number: 17839326.0
(22) Date of filing: 03.08.2017
(51) Int. Cl.: H01L 21/677, H01L 21/02, H01L 21/67

(54) **SEMICONDUCTOR MANUFACTURING APPARATUS**
VORRICHTUNG ZUR HERSTELLUNG VON HALBLEITERN
APPAREIL DE FABRICATION DE SEMI-CONDUCTEURS

(30) Priority: 09.08.2016 JP 2016156445
(43) Date of publication of application: 19.06.2019
(73) Proprietor: Kondoh Industries, Ltd., Tokyo 105-0014 (JP)
(72) Inventor: KISAKIBARU, Toshiro, Tokyo 105-0014 (JP); UENO, Kouta, Tokyo 105-0014 (JP); HONBORI, Isao, Tokyo 105-0014 (JP); SUGIYAMA, Satoki, Tokyo 105-0014 (JP)
(74) Representative: Thum, Bernhard
(86) International application number: PCT/JP2017/028182
(87) International publication number: WO 2018/030255

(56) References cited:
- JP-A- H10 180 209
- JP-A- 2000 195 930
- JP-A- 2005 150 706
- JP-A- 2005 354 025
- JP-A- 2015 146 348
- US-B2- 9 352 364

## Description

### Technical Field

The present invention relates to an apparatus for manufacturing semiconductors. Specifically, it relates to an apparatus for manufacturing the semiconductors that prevents water from adhering to a wafer that is transported in an Equipment Front End Module (EFEM).

### Background Art

A wafer that has been processed by processing equipment of an apparatus for manufacturing semiconductors is taken out by means of a robot of an EFEM and is placed in a Front Opening Unified Pod (FOUP), which is an airtight container for transporting wafers. Thus, an idea to fill a FOUP with an inert gas to prevent any corrosion is proposed (see Patent Literature 1).

Air from a clean room is cleaned and introduced into the EFEM by means of a fan and filter unit that is provided in the ceiling of the EFEM. The fan and filter unit removes particles and polluted gas from the air from the clean room by means of the filter and downwardly blows out the air. The air in the clean room is normally at about a temperature of 22 - 23 °C and at about a humidity of 45%. Thus, since the surface of a wafer is exposed to the air at a temperature of 22 - 23 °C and at a humidity of 40%, moisture may adhere to the surface of it.

If moisture adheres to the surface of the wafer, the adhering moisture may react with any residue or with any residual gas during storage in the FOUP, even though the FOUP is filled with an inert gas. Thus, an acidic liquid may be generated to cause a wire of Al or Cu to corrode, or to cause a film that is formed in the wafer to deteriorate. If much moisture adheres to the surface of the wafer, the reaction that arises on the surface of the wafer cannot be stopped even though the FOUP is filled with an inert gas. As the manufacturing process is a so-called 20 nm generation and semiconductor products have become finer, controlling moisture on the surface of the wafer after being processed greatly affects the yield.

A method for preventing moisture from adhering to the surface of the wafer in the EFEM can be conceived. It would dehumidify blowing or circulating air by means of a cold source and absorb moisture by means of a moisture absorbent, such as a zeolite, so as to control the humidity so that it is kept low. However, using both a cold source and a moisture absorbent causes the size of an apparatus to be large and the initial cost and running cost to increase. These are problems.

Another method is also studied, wherein an inert gas, such as N₂, is filled in the EFEM. However, filling the EFEM with an inert gas causes a problem for people in that the method is unsafe.

Therefore, the present invention aims to provide an apparatus for manufacturing semiconductors, by which adhesion of moisture to the surface of a wafer in an EFEM is easily prevented.

### Prior-art Publication

### Patent Literature

Patent Literature 1: JP 2012-248 887 A
Patent Literature 2: JP 2015-146 348 A

Patent Literature 2 may be construed to disclose an EFEM system capable of transporting wafers without exposing them to atmosphere which causes a change in surface properties and adhesion of particles. Said EFEM system comprises a plurality of EFEMs having wafer transport apparatuses for transporting wafers therein, a gas cleaning apparatus provided outside of EFEMs, and having a dust filter for cleaning the gas, a gas supply channel for distributing the gas cleaned by the gas cleaning apparatus, and supplying the gas to each of wafer transport apparatuses and a gas feedback channel for returning the gas emitted from each of wafer transport apparatuses to the gas cleaning apparatus. Nitrogen is made to cycle between the wafer transport apparatuses and the gas cleaning apparatus.

### Disclosure of Invention

An apparatus for manufacturing semiconductors according to independent claim 1 is provided.

By this configuration, the ultrasonic waves can be applied to the wafer that is transported in the EFEM and that has been processed. Since the ultrasonic waves are applied from the vibrator to the wafer, standing waves are created between them. On the surface of the wafer adiabatic expansion and adiabatic compression are repeated at an ultrasonic frequency, so that molecules of water are separated from the surface of the wafer. Thus, adhesion of moisture to the surface of the wafer is prevented. Further, since adhesion of moisture to the surface of the wafer is prevented by adding the ultrasonic oscillator and the vibrator to the conventional EFEM, the apparatus is simple.

Further by this configuration, the molecules of water are separated and removed from the surface of the wafer.

A development is shown in dependent claim 2. By this configuration, since the molecules of water are removed from multiple points of the surface of the wafer, adhesion of moisture to the surface of the wafer is definitely prevented.

A further development is shown in dependent claim 3. By this configuration, since the molecules of water that have been separated from the surface of the wafer are sent to the side by the airflow from above, they are easily removed.

A further development is shown in dependent claim 4. By this configuration, the wafer is vibrated at an ultrasonic frequency by means of the vibrator to generate the ultrasonic waves. The generated ultrasonic waves are reflected by the reflective board to create the standing waves between the wafer and the reflective board. Thus, the molecules of water on the surface of the wafer are separated to prevent moisture from adhering to it.

A further development is shown in dependent claim 5. By this configuration, since the ultrasonic waves are definitely applied to the wafer while the transportation is stopped, moisture is easily removed from the surface of the wafer.

A further development is shown in dependent claim 6. By this configuration, since the standing waves at an ultrasonic frequency are easily created between the vibrator and the wafer, moisture is easily removed from the surface of the wafer.

A further development is shown in dependent claim 7. By this configuration, since the temperature at the surface of the wafer that is exposed to the pulsed light is raised, moisture is easily removed from the surface of the wafer.

A further development is shown in dependent claim 8. By this configuration, the ultrasonic waves are applied to the entire surface of the wafer by using a small vibrator, so that it is not necessary to use a vibrator that is large enough to cause ultrasonic waves to be applied to the entire surface of the wafer.

A further development is shown in dependent claim 9. By this configuration, since the wafer to which the ultrasonic waves are applied is exposed to the pulsed light, moisture is efficiently removed from the surface of the wafer.

A further development is shown in dependent claim 10. By this configuration, since the vibrator is formed by sandwiching the multiple oscillators by means of the vibrating plates, a vibrator that has a size to suit the size of the wafer can be easily formed. Further, since the vibrating plates sandwich the oscillators, any possible damage to the oscillators during an operation can be prevented.

A further development is shown in dependent claim 11. By this configuration, since the vibrator is formed by enclosing the multiple oscillators in the space formed by the vibrating plates and the side plate and by filling the space with the liquid, a vibrator that has a size to suit the size of the wafer can be easily formed. Further, since the oscillators operate in the liquid, any possible damage to the oscillators during an operation can be prevented.

Since the apparatus preferably has a vibrator by which ultrasonic waves are applied to a wafer that is transported by the EFEM, standing waves are formed between the vibrator and the wafer. The standing waves have nodes and antinodes. At the antinodes adiabatic expansions and adiabatic compressions are repeated at an ultrasonic frequency. The adiabatic expansions and the adiabatic compressions on the surface of the wafer cause molecules of water to be separated from the surface. Thus molecules of water on the surface of the wafer are removed. So, an apparatus for manufacturing semiconductors that can easily prevent moisture from adhering to the surface of the wafer in the EFEM is provided.

The use of the articles "a," "an," and "the" and similar referents in the specification and claims are to be construed to cover both the singular and the plural form of a noun, unless otherwise indicated herein or clearly contradicted by the context. The use of any and all examples, or exemplary language (e.g., "such as") provided herein is intended merely to better illuminate the invention, which is defined by the appended claims.

### Brief Description of Drawings

[Fig. 1]

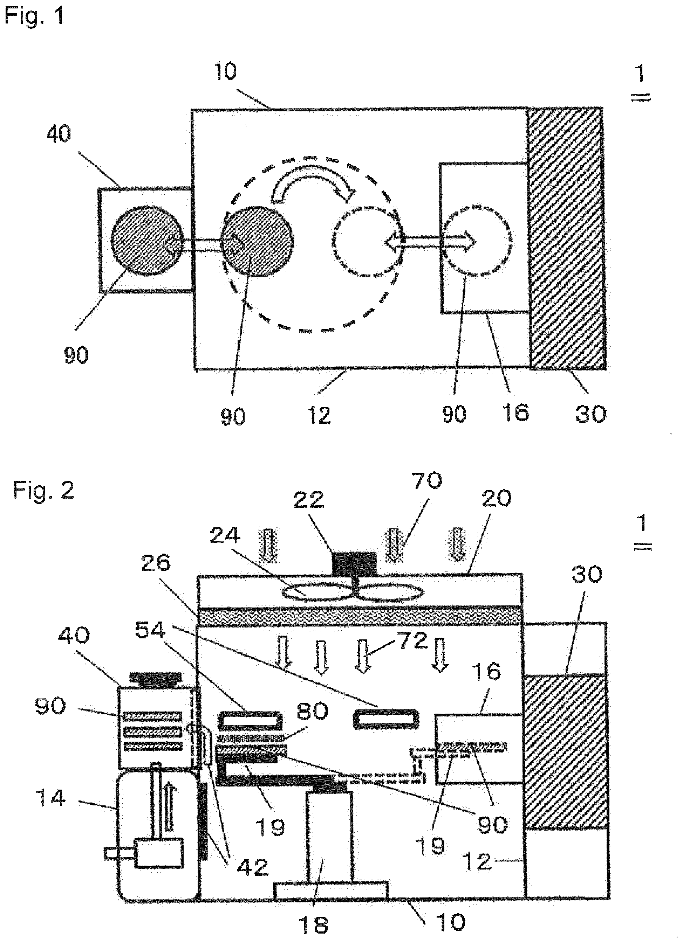

   Fig. 1 is an overall plan view of the apparatus for manufacturing the semiconductors as an embodiment of the present invention.
[Fig. 2]
   Fig. 2 is a sectional side view of the apparatus for manufacturing the semiconductors as in Fig. 1.
[Fig. 3]

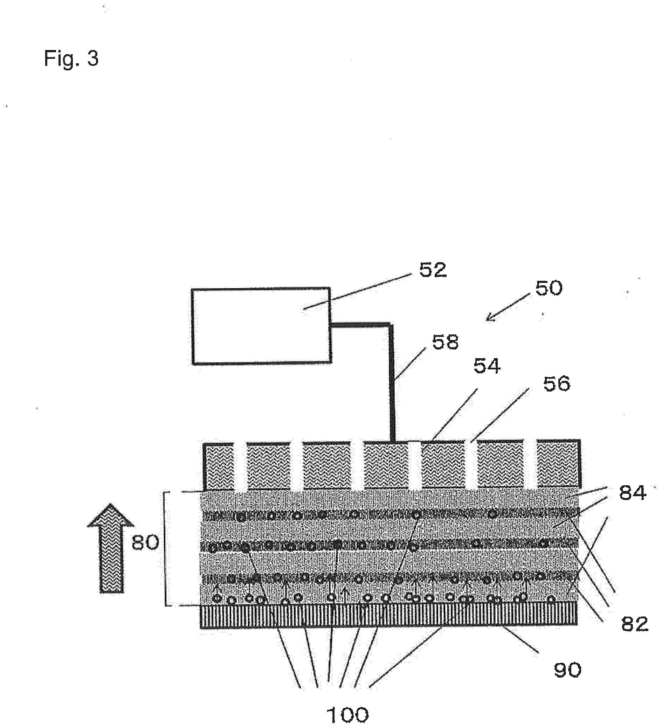

   Fig. 3 shows an example where moisture is removed by applying ultrasonic waves to a wafer by means of an ultrasonic generator that has an ultrasonic oscillator and a vibrator.
[Fig. 4]

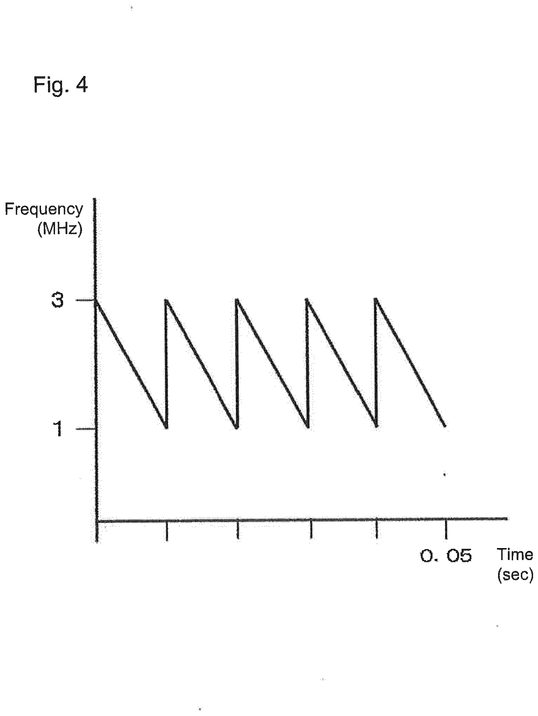

   Fig. 4 shows an exemplary change of the pattern of frequencies of ultrasonic waves that is used in the embodiment.
[Fig. 5]

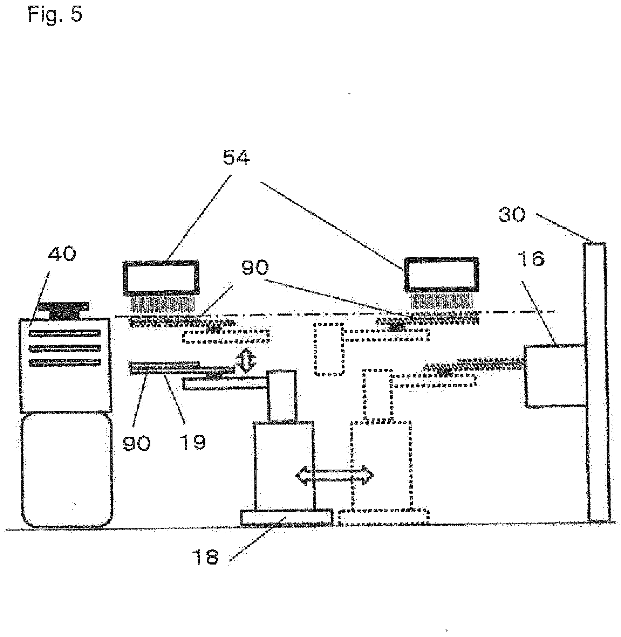

   Fig. 5 is a sectional side view of the apparatus for manufacturing the semiconductors that has multiple ultrasonic generators as an embodiment of the present invention.
[Fig. 6]

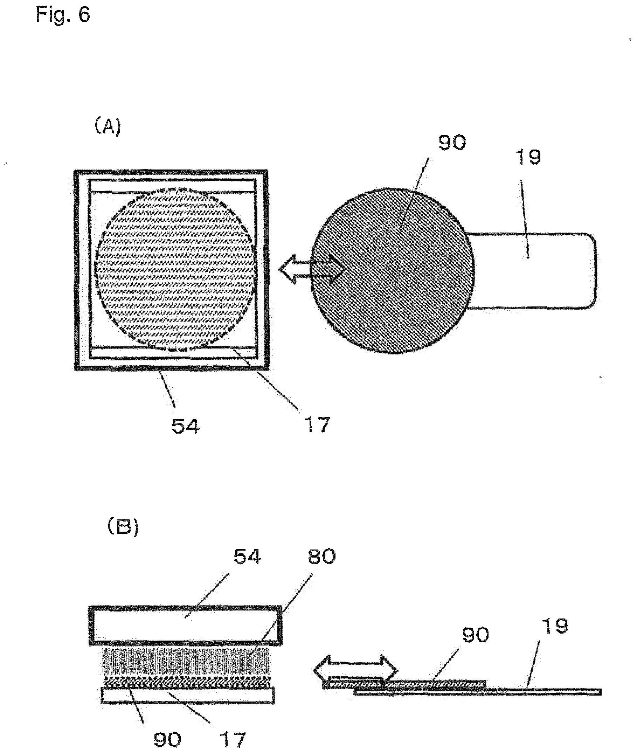

   Fig. 6(a) illustrates a wafer being placed on a table for placing a wafer. Fig. 6(b) illustrates the ultrasonic waves being applied to the wafer on the table for placing the wafer.
[Fig. 7]

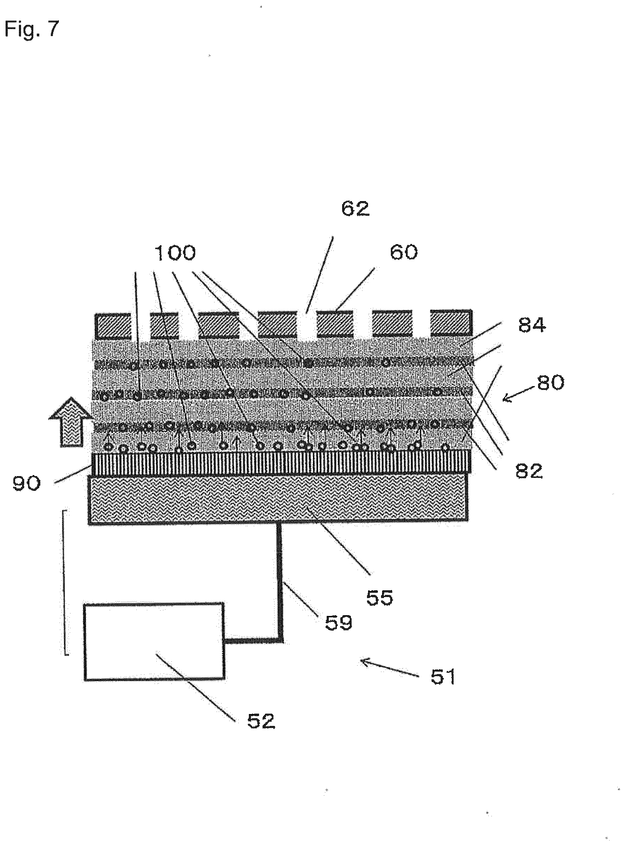

   Fig. 7 shows an example where moisture is removed by applying ultrasonic waves to a wafer by means of an ultrasonic generator as another embodiment of the present invention.
[Fig. 8]

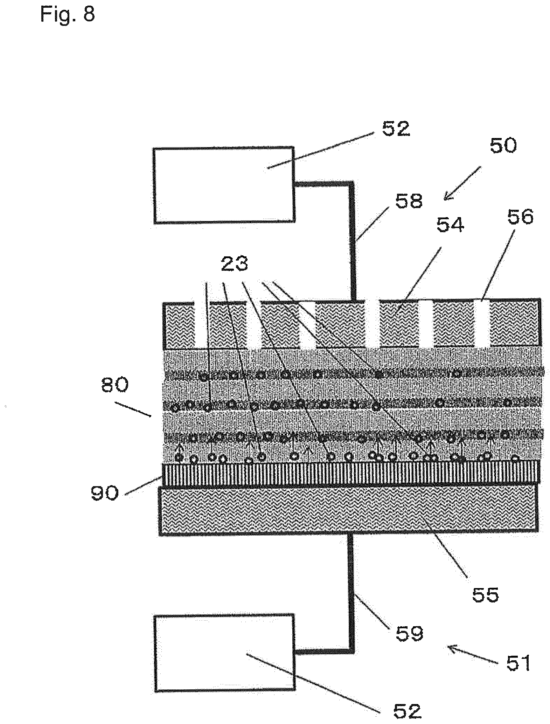

   Fig. 8 shows an example where moisture is removed by applying ultrasonic waves to a wafer by means of an ultrasonic generator as yet another embodiment of the present invention.
[Fig. 9]

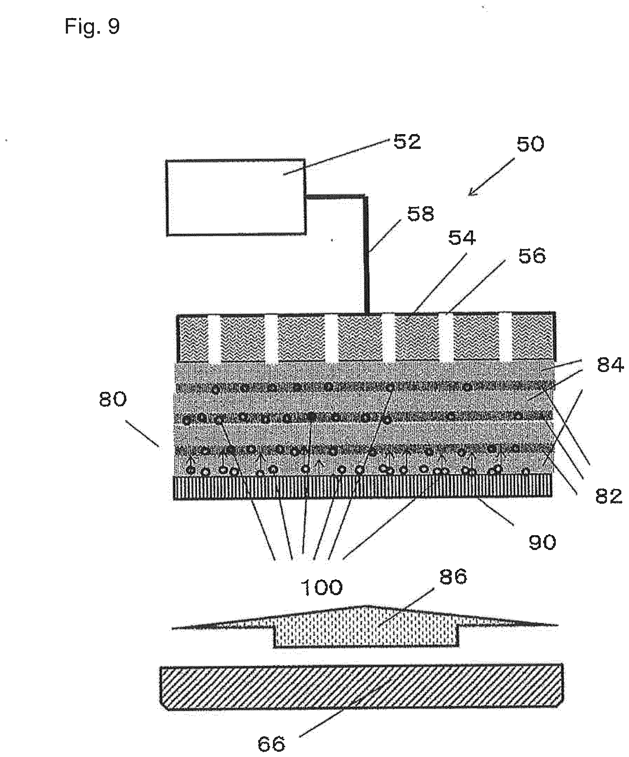

   Fig. 9 shows an example where moisture is removed by applying ultrasonic waves to a wafer by means of an ultrasonic generator as the embodiment of the present invention and by exposing the wafer to pulsed light by means of a lamp.
[Fig. 10]

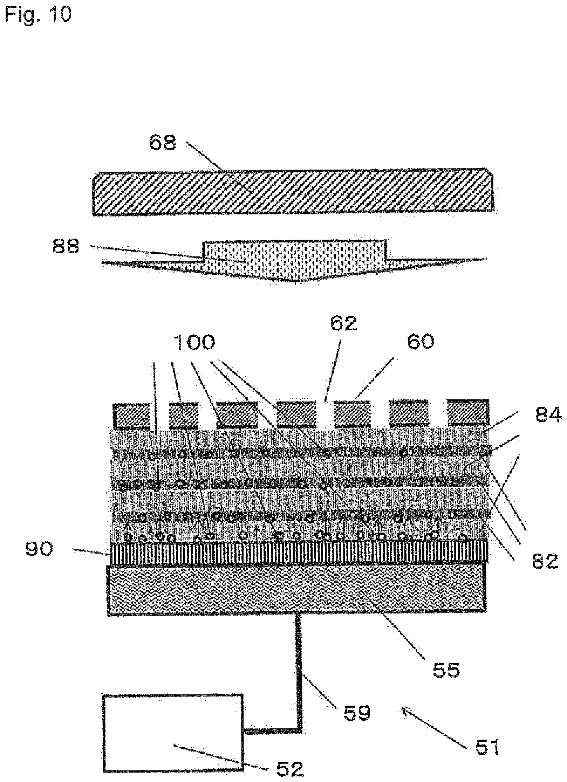

   Fig. 10 shows another example where moisture is removed by applying ultrasonic waves to a wafer by means of an ultrasonic generator as the embodiment of the present invention and by exposing the wafer to pulsed light by means of a lamp.
[Fig. 11]

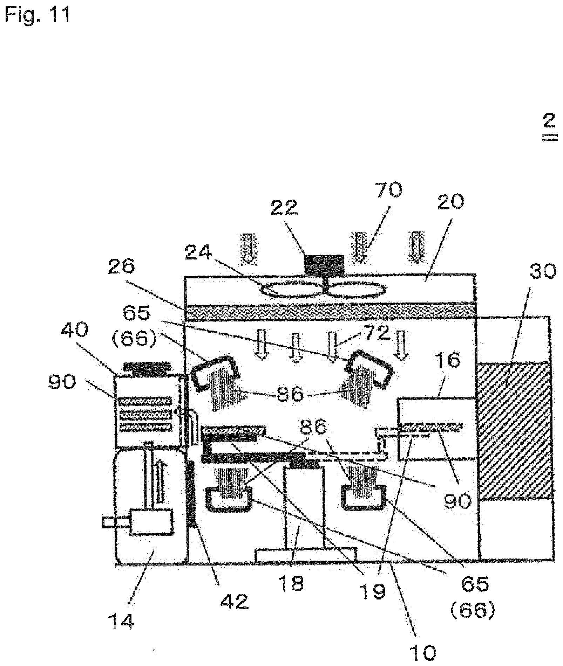

   Fig. 11 is a sectional side view of an apparatus for manufacturing the semiconductors that has a pulsed-light generator.
[Fig. 12]

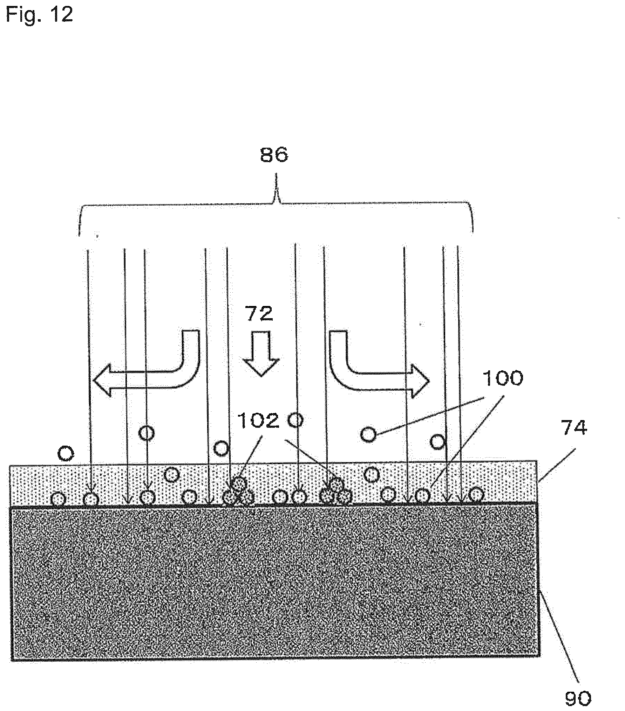

   Fig. 12 shows an example where moisture is removed by exposing a wafer to pulsed light.
[Fig. 13]

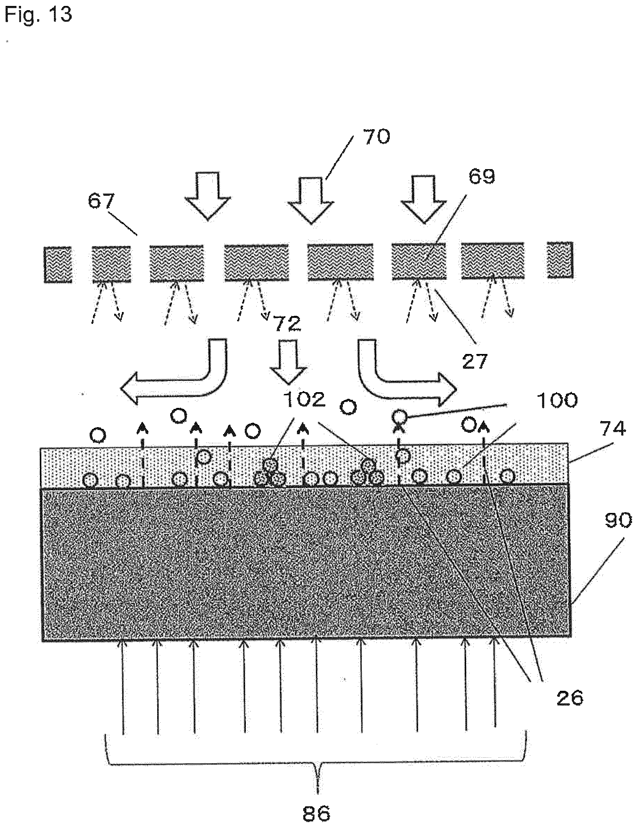

   Fig. 13 shows another example where moisture is removed by exposing a wafer to pulsed light.
[Fig. 14]

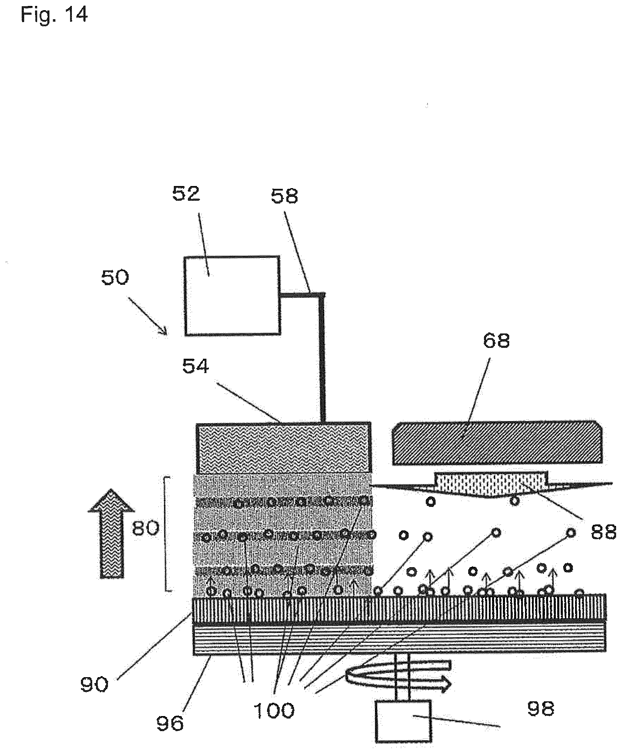

   Fig. 14 shows another example where moisture is removed by applying ultrasonic waves to a wafer that rotates and by exposing the wafer to pulsed light.
[Fig. 15]

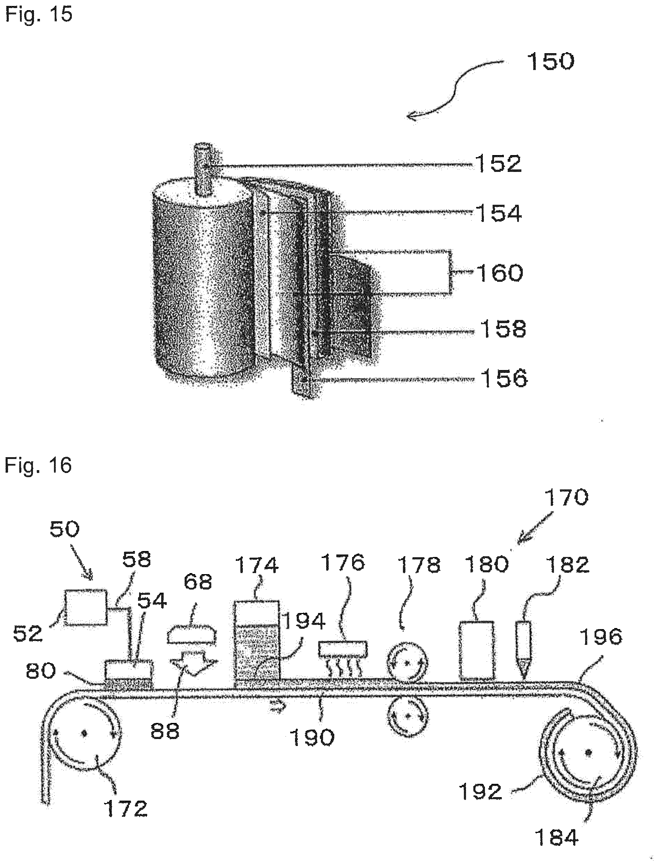

   Fig. 15 illustrates a structure of a lithium-ion battery.
[Fig. 16]
   Fig. 16 shows another embodiment of the present invention, wherein an apparatus for manufacturing lithium-ion batteries has a vibrator for generating ultrasonic waves and a lamp for exposing a wafer to pulsed light, so that moisture is removed from an electrode.
[Fig. 17]

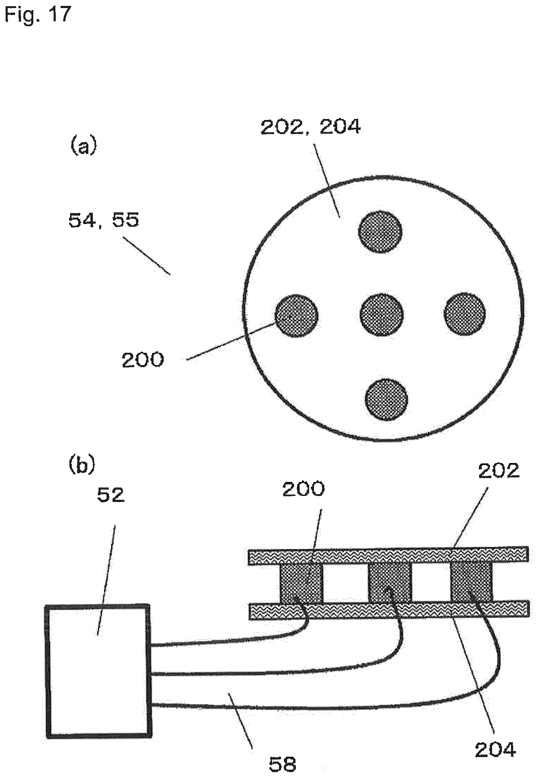

   Fig. 17 illustrates a structure of a vibrator. Fig. 17(a) is a cross-section that is perpendicular to the vibrating direction. Fig. 17(b) shows a cross-section that is perpendicular to that in Fig. 17(a) and shows the ultrasonic oscillator.
[Fig. 18]

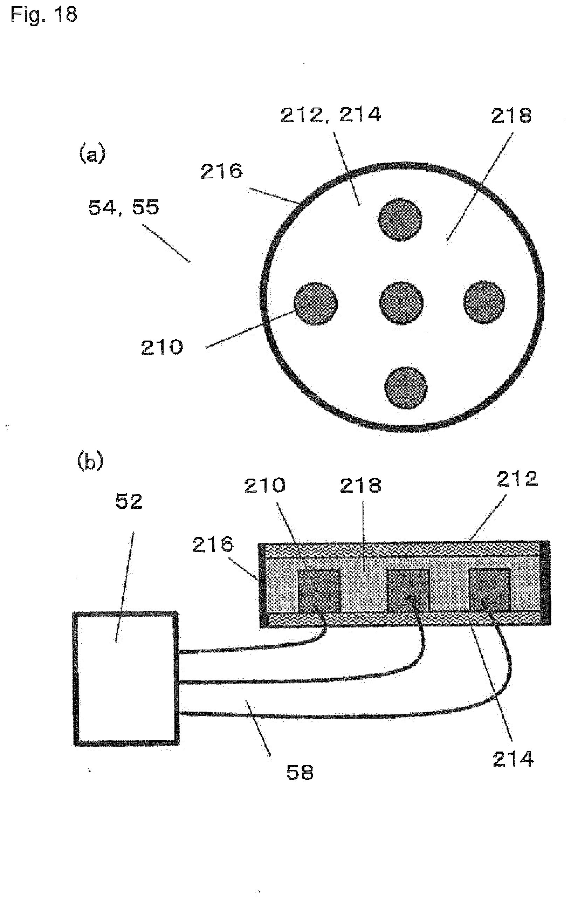

   Fig. 18 illustrates a structure of a vibrator that differs from the one in Fig. 17. Fig. 18(a) is a cross-section that is perpendicular to the vibrating direction. Fig. 18(b) shows a cross-section that is perpendicular to that in Fig. 18(a) and shows the ultrasonic oscillator.

### Mode for Carrying Out the Invention

Below, with reference to the drawings, some embodiments of the present invention are discussed. In the drawings, the same or corresponding elements are denoted by the same reference numbers so that duplicate explanations are omitted. Fig. 1 is a schematic plan view of an apparatus 1 for manufacturing semiconductors, which is an embodiment of the present invention. Fig. 2 is a schematic side view of the apparatus 1 for manufacturing the semiconductors. The apparatus 1 for manufacturing the semiconductors has processing equipment 30 that processes wafers 90. It also has a FOUP 40 that is an airtight container for transporting the wafers that supplies the wafers 90 to be processed and houses those that have been processed. It also has an EFEM 10 that transports the wafers 90 between the FOUP 40 and the processing equipment 30.

The "processing" may be any kind of processing of the wafer 90, such as polishing the surface of the wafer 90, forming an oxidized or nitride film, applying a photoresist, exposing, developing, etching, peeling a resist and cleaning, forming an insulated layer, flattening, forming a gate layer, forming a pattern of a gate layer, ion-implanting and annealing, forming an insulated film between layers and flattening the film, forming wiring, and inspecting a wafer.

The EFEM 10 is located in front of the processing equipment 30 to take the wafer 90 out of the FOUP 40, to transport it to the processing equipment 30, and to return the wafer 90 that has been processed by the processing equipment 30 to the FOUP 40. The EFEM 10 has a frame 12 for being isolated from surroundings and a fan and filter unit 20 that is provided on the ceiling of the frame 12. By the fan and filter unit 20 a fan 24 is rotated by a driving motor 22 to introduce air 70 that is in a clean room (not shown) into the frame 12. The apparatus 1 for manufacturing the semiconductors is located in the clean room. A filter 26 removes particles and polluted gas from the air that is introduced into the frame 12 by means of the fan 24. Namely, an airflow of clean air 72 is generated in the frame 12. The EFEM 10 has a port 14 for loading on which the FOUP is placed. The port 14 is located outside the frame 12. Further, it has a load-lock chamber 16. The load-lock chamber 16 is used to prevent the inside of the processing equipment 30 from opening to the EFEM 10 when putting in the wafer 90 to be processed and taking out the one that has been processed.

The FOUP 40 that houses some wafers 90 that have not been processed is placed on the port 14 of the EFEM 10. When it is placed there, a door 42 of the FOUP 40 is opened so that the inside of the FOUP 40 communicates with the inside of the EFEM 10. The wafer 90 can be taken out of the FOUP 40. Racks for storing the wafers 90 are provided in the FOUP 40. A wafer 90 can be taken out of, and can be put on, each of the racks. The wafer 90 that has been processed by the processing equipment 30 is returned to the FOUP 40. When a predetermined number of processed wafers 90 are housed in the FOUP 40, the door 42 is closed. An inert gas, such as N₂, is filled in the FOUP 40. Then the FOUP 40 is transported from the port 14 for loading to a place for a next process or for a temporary storage.

The EFEM 10 has a robot 18 that transfers the wafer 90 into the frame 12. The robot 18 is fixed to the floor of the EFEM 10. It has an arm 19. It holds the wafer 90 by the arm 19 to take it out of the FOUP 40, transport it to the load-lock chamber 16, and transport it from the load-lock chamber 16 into the FOUP 40. The arm 19 may have at the tip of it a receiver for the wafer (not shown) that receives the wafer 90 on it, or may have at the tip of it a gripper on the wafer (not shown) that grips the outer circumference of the wafer 90. Or it may have any other known means to hold the wafer 90.

The EFEM 10 has an ultrasonic generator 50 (see Fig. 3) for exposing the wafer 90 to ultrasonic waves 80, which wafer is being transported by the robot 18. The ultrasonic generator 50 has an ultrasonic oscillator 52 that generates high-frequency power. It also has a vibrator 54 that generates the ultrasonic waves 80 from the high-frequency power that is generated by the ultrasonic oscillator 52 to expose the wafer 90 to the ultrasonic waves 80. It also has a cable 58 that transmits the high-frequency power generated by the ultrasonic oscillator 52 to the vibrator 54. It may have one ultrasonic oscillator 52 and some vibrators 54 so that the wafer 90 is exposed to the ultrasonic waves 80 that are generated by multiple vibrators 54. Alternatively, the EFEM 10 may have multiple ultrasonic generators 50 so that the wafer 90 is exposed to the ultrasonic waves 80 that are generated by multiple vibrators 54. The wording "the wafer 90 is exposed to the ultrasonic waves" means that the ultrasonic waves are generated in air to be transmitted to the wafer 90 or that the vibrator 54 contacts the wafer 90 to directly transmit the ultrasonic vibrations.

The processing equipment 30 takes in the wafer 90 from the load-lock chamber 16, processes it, and returns it to the load-lock chamber 16. The processing equipment 30 is kept in a vacuum or in an inert gas environment, depending on the process. Thus no substantial adhesion of water to the processed wafer 90 occurs.

Next, transportation of the wafer 90 in the apparatus 1 for manufacturing the semiconductors is discussed. The FOUP 40 that houses wafers 90 to be processed is placed on the port 14 for loading by a means for transporting the FOUP (not shown). The FOUP 40 is filled with an inert gas. When the FOUP 40 is placed on the port 14 for loading, the door 42 is opened. The door 42 is preferably opened by using the robot 18.

When the door 42 is open, the robot 18 holds one of the wafers 90 by means of the arm 19 to take it out of the FOUP 40. It transports the wafer 90 to the load-lock chamber 16. In that transportation, the wafer 90 is exposed to clean air 72 that flows from the fan and filter unit 20 that is located above the wafer 90. The wafer 90 that is placed in the load-lock chamber 16 is fed to the processing equipment 30 to be processed. The wafer 90 that has been processed by the processing equipment 30 is returned from the processing equipment 30 to the load-lock chamber 16.

After the robot 18 transports one of the wafers 90 from the FOUP 40 to the load-lock chamber 16, it holds the processed wafer 90 in the load-lock chamber 16 to return it to the FOUP 40. The load-lock chamber 16 is preferably configured to house multiple wafers 90, such as a wafer 90 to be processed and one that has been processed. In the transportation of the wafer 90 from the load-lock chamber 16 to the FOUP 40, the wafer 90 is exposed to the clean air 72 that flows from the fan and filter unit 20 that is located above the wafer 90.

The clean air 72 is the air in the clean room and is generally at a temperature of 22 - 23 °C and at a humidity of about 45%. Thus, when the clean air 72 touches the surface of the wafer 90, moisture adheres there. To remove the moisture, the surface of the wafer 90 is exposed to the ultrasonic waves 80 from the ultrasonic generator 50. Typically, the upper surface of the wafer 90 is exposed to the ultrasonic waves 80 from the vibrator 54 that is provided above the wafer 90 that is transported by means of the robot 18.

As in Fig. 3, since the wafer 90 is exposed to the ultrasonic waves 80 from the vibrator 54, the standing waves of the ultrasonic waves 80 are generated between the vibrator 54 and the surface of the wafer 90. Namely, antinodes 84 of the standing waves are generated on the vibrator 54 and on the surface of the wafer 90. The nodes 82 and the antinodes 84 are generated between them. Incidentally, the number of waves (number of nodes 82 and antinodes 84) between the vibrator 54 and the surface of the wafer 90 is not specifically limited, and may be one (only one node 82). On the surface of the wafer 90, which is the antinode 84, the adiabatic expansion and the adiabatic compression are repeated at an ultrasonic frequency. Because of the repetition of the adiabatic expansion and the adiabatic compression at the ultrasonic frequency, the molecules 100 of water are separated from the surface of the wafer 90. The molecules 100 of water that have been separated move to the node 82.

The ultrasonic frequency of the ultrasonic waves 80 is preferably changed as in Fig. 4. For example, the frequency of the ultrasonic waves 80 is changed from 38 kHz to 33 kHz in 0.05 sec to lengthen the standing waves. Since the length is increased, the node 82 becomes far from the surface of the wafer 90. The molecules 100 of water that have been separated from the surface of the wafer 90 follow the movement of the node. As a result, the molecules 100 of water become far from the surface of the wafer 90. Next, the frequency of the ultrasonic waves 80 is quickly returned to 38 kHz. The molecules 100 of water at the node 82 of the standing waves cannot follow the movement of the node 82 and are left so that they are positioned at or near the antinode 84 of the standing waves. After that, they move to the node 82. Thus, some of the molecules 100 of water may move to the node 82, which is the second node from the surface of the wafer 90. By repeating the changes of the frequency of the ultrasonic waves in a sawtooth waveform, the molecules 100 of water become far from the surface of the wafer 90. At this moment, if the wafer 90 is stopped to be exposed to the ultrasonic waves, or if the standing waves of the ultrasonic waves break down, the molecules 100 of water are prevented from immediately adhering to the surface of the wafer 90. That is, the wafer 90 may be moved during that period. The "moment" when the frequency is increased may be a period that is shorter than the period that is used for lowering the frequency. If the rate of change of the frequency is high, the molecules 100 of water hardly follow the movement of the node 82. Typically, the moment is a period that makes a frequency so high that the molecules 100 of water hardly follow the movement of the node 82. The change of frequency of the waves as in Fig. 4 is discussed as an example. For example, the sonic velocity is assumed to be 340 m/sec. Thus, the length of the ultrasonic waves is 113 µm at 3 MHz and 340 µm at 1 MHz. The distance that the node 82 moves is 57 µm when the frequency of the standing waves is changed between 3 MHz and 1 MHz. The period for changing the frequency from 3 MHz to 1 MHz is assumed to be 10 msec and the period for changing it from 1 MHz to 3 MHz is assumed to be 10 µsec. The speeds of the node during the change of the frequency are calculated as 5.7 mm/sec and 5.7 m/sec. The molecules 100 of water that gather in the node 82 become far from the surface of the wafer 90 at a speed of 5.7mm/sec when the frequency is changed from 3 MHz to 1 MHz. When the frequency is changed from 1 MHz to 3 MHz the speed of the node 82 is 5.7 m/sec. This is so high that the molecules 100 of water hardly follow. Thus the molecules 100 of water may be unable to follow the movement of the node 82, and they are left. By repeating the changes of the frequency, the molecules 100 of water become far from the surface of the wafer 90. The ultrasonic frequency and the period for changing the frequency are preferably adjusted based on the surface of the wafer, the number of molecules of water that adhere to the surface, etc.

The period that the wafer 90 is exposed to the ultrasonic waves 80 may be short, as shown in Fig. 4. Thus, the wafer 90 may be exposed to the ultrasonic waves 80 while the wafer 90 is being transported by means of the robot 18, namely, during the transportation of the wafer 90. In so doing, as in Fig. 5 the arm 19 may vertically move to adjust the distance between the vibrator 54 and the wafer 90. Alternatively, the vibrator 54 may vertically move to adjust the distance between the vibrator 54 and the wafer 90. When the distance between the vibrator 54 and the wafer 90 is adjusted, the standing waves are easily formed. Further, moisture is prevented from again adhering to the surface of the wafer 90 after the moisture is removed from the surface of the wafer 90 by exposing the wafer 90 to the ultrasonic waves 80. Incidentally, the distance between the vibrator 54 and the wafer 90 may be the length of one ultrasonic wave or longer. In considering damping, a short distance is preferable.

As in Fig. 6, the ultrasonic generator 50 may have a table 17 for placing the wafer on which the wafer 90 is placed. The arm 19 temporarily places the wafer 90 on the table 17 for placing the wafer. The wafer 90 that is placed on the table 17 for placing the wafer is exposed to the ultrasonic waves 80 that are generated by the vibrator 54. Since the wafer 90 is placed on the table 17 for placing the wafer, the position of the wafer 90 can be stabilized. The table 17 for placing the wafer may vertically move the wafer 90 to adjust the distance between the vibrator 54 and the wafer 90. The wafer 90 on the table 17 for placing the wafer, which wafer has been exposed to the ultrasonic waves 80, is held by the arm 19 to be again transported. While the wafer 90 is exposed to the ultrasonic waves, the arm 19 may stop transporting the wafer 90. Or, the vibrator 54 may move to follow the wafer 90 that is being transported to expose the wafer 90 to the ultrasonic waves 80. Incidentally, since the ultrasonic waves 80 have a high frequency, the adiabatic expansion and the adiabatic compression repeat within a short period. Usually, it is enough that the wafer 90 is exposed to the ultrasonic waves 80 while it is being transported. This way is efficient. While the wafer 90 is exposed to the ultrasonic waves 80, the table 17 for placing the wafer may be rotated to rotate the wafer 90 (rotate as in the sheet of Fig. 6(A)). Since the wafer 90 rotates, the molecules 100 of water that have been separated from the surface of the wafer 90 easily dissipate. Further, when the wafer 90 rotates, it is not necessary to use a vibrator that is large enough to cause ultrasonic waves 80 to be applied to the entire surface of the wafer 90. A small vibrator 54 may be used. The small vibrator 54 may be, for example, long and thin to cover an area with a specified width that extends a distance that equals the distance to the radius of the surface of the wafer 90.

As in Fig. 3, multiple apertures 56 are preferably formed in the vibrator 54. The molecules 100 of water that have been separated from the surface of the wafer 90 can easily pass through the apertures 56 to leave the space between the wafer 90 and the vibrator 54. They can dissipate through the sides of that space. But when the distance is small they preferably dissipate through the apertures 56 of the vibrator 54 in addition to the sides.

As in Fig. 5, preferably multiple vibrators 54 are provided so that moisture is removed from the wafer 90 just before being transported to the load-lock chamber 16 and from the wafer 90 just before being housed in the FOUP 40. By exposing the wafer 90 to the ultrasonic waves 80 multiple times the moisture can be thoroughly removed.

The wafer 90 that is exposed to the ultrasonic waves 80 that are generated by the ultrasonic generator 50 so that moisture is removed is transported to the load-lock chamber 16 or to the FOUP 40. The wafer 90 that has been transported to the load-lock chamber 16 is processed by the processing equipment 30. When the FOUP 40 houses a predetermined number of wafers 90, the door 42 is closed and an inert gas is filled in it. Then the FOUP 40 is stored in a stocker for storing FOUPs (not shown) or is transported to the place for a next process or for shipment.

Fig. 7 shows an ultrasonic generator 51 that differs from the ultrasonic generator 50 as in Fig. 3. The ultrasonic generator 51 has the ultrasonic oscillator 52 and the vibrator 55. The wafer 90 is put on the vibrator 55. The vibrator 55 generates the ultrasonic waves 80 by using the high-frequency power that is generated by the ultrasonic oscillator 52. The ultrasonic generator 51 also has a cable 59 that transmits high-frequency power generated by the ultrasonic oscillator 52 to the vibrator 55. It also has a reflective board 60 that faces the wafer 90 on the vibrator 55. In the ultrasonic generator 51 the ultrasonic vibrations of the vibrator 55 are transmitted to the wafer 90 so that the standing waves at the ultrasonic frequency are generated between the wafer 90 and the reflective board 60. The reflective board 60 only has to reflect the ultrasonic waves that are generated by the wafer 90 on the vibrator 55. It has a flat face that faces the wafer 90, which is parallel to the wafer 90. The thickness and material of the reflective board 60 only have to have stiffness to reflect the ultrasonic waves 80, and are not necessarily limited. It may have one ultrasonic oscillator 52 and some vibrators 55, like the ultrasonic generator 50. Further, multiple apertures 62 are preferably formed in the reflective board 60 so that moisture dissipates through them. The apparatus 1 for manufacturing the semiconductors may comprise the ultrasonic generator 51 instead of the ultrasonic generator 50.

In an embodiment as in Fig. 8, the ultrasonic generator 50 as in Fig. 3 and the ultrasonic generator 51 as in Fig. 7 are provided so that they face each other. Namely, the ultrasonic generator 51 as in Fig. 7 has the vibrator 54 of the ultrasonic generator 50 as in Fig. 3, instead of the reflective board 60. By this configuration, since the ultrasonic waves 80 are generated by both the wafer 90 on the vibrator 55 and the vibrator 54, strong standing waves are generated between the wafer 90 and the vibrator 54. In this case, the ultrasonic waves 80 generated by the ultrasonic generator 50 and those generated by the ultrasonic generator 51 are configured to have the same frequency and the same phase, so that they resonate.

In an embodiment as in Fig. 9, a lamp 66 is provided to expose the wafer 90 to pulsed light 86. The wafer 90 is exposed to the ultrasonic waves 80 generated by the ultrasonic generator 50 as in Fig. 3. By this configuration, since the wafer 90 is exposed to the pulsed light 86, the temperature of the surface of the wafer 90 rises to heat a boundary-air layer 74 (see Fig. 12) that contacts the surface of the wafer 90. When the temperature of the boundary-air layer 74 rises, the relative humidity decreases, so that the molecules 100 of water that adhere to the surface of the wafer 90 easily separate from the surface. Here, the boundary-air layer 74 is some µm thick to some tens of µm thick. Thus by exposing the wafer 90 to the ultrasonic waves 80 by means of the ultrasonic generator 50 and by exposing it to the pulsed light 86, moisture is easily removed. Incidentally, if the wafer 90 were exposed to continuous light from the lamp 66, the temperature of the devices in the EFEM 10 other than the wafer 90 would rise. Thus it is exposed to the pulsed light 86 from the lamp 66. For example, the temperature of the surface of the wafer 90 and the boundary-air layer 74 rises to 80 - 100 °C by means of the pulsed light 86. If the relative humidity of the clean air 72 is 40% at 22 - 23 °C, it becomes 2.23% when the temperature of the boundary-air layer 74 rises to 80 °C, 1.04% at 100 °C, and 0.87% at 105 °C. As is obvious from the above, by heating the boundary-air layer 74, moisture on the surface of the wafer 90 is efficiently removed.

In an embodiment as in Fig. 10, a lamp 68 is provided to expose the wafer 90 to pulsed light 88. The wafer 90 is exposed to the ultrasonic waves 80 generated by the ultrasonic generator 51 as in Fig. 7. By this configuration, the surface of the wafer 90 that is exposed to the ultrasonic waves 80 is exposed to the pulsed light 88. The pulsed light 88 reaches the wafer 90 from the lamp 68 that is located behind the reflective board 60 because it passes through apertures 62 that are formed in the reflective board 60.

The above discussion says that moisture is removed by exposing the wafer 90 that is transported by the EFEM 10 to the ultrasonic waves 80 by using the ultrasonic generators 50, 51. Further, it says that the efficiency to remove moisture increases by exposing the wafer 90 to the pulsed light 88. However, moisture can be removed only by exposing the wafer 90 to the pulsed light 88.

Fig. 11 shows a sectional view of an apparatus 2 for manufacturing semiconductors that has a pulsed-light generator 65 instead of the ultrasonic generator 50. The apparatus 2 for manufacturing the semiconductors is the same as the apparatus 1 for manufacturing the semiconductors as in Figs. 1 and 2, except that it has the pulsed-light generator 65 instead of the ultrasonic generator 50. The pulsed-light generator 65 may apply the pulsed light 86 to the wafer 90 from above or from below. The apparatus 2 for manufacturing the semiconductors may have multiple pulsed-light generators 65. Alternatively, one pulsed-light generator 65 may have multiple lamps 66.

As in Fig. 12, when the wafer 90 is exposed to the pulsed light 86 the temperature of the boundary-air layer 74 rises so that the molecules 100 of water on the surface of the wafer 90 separate. The airflow of the clean air 72 from the fan and filter unit 20 touches, or is interrupted by, the surface of the wafer 90, so that the clean air 72 flows to the side together with the molecules 100 of water. Thus, the molecules 100 of water are removed. Further, a reaction product 102, such as an acid, that adheres to the surface of the wafer 90, vaporizes and is removed together with the molecules 100 of water. Thus, by exposing the surface of the wafer 90 to the pulsed light 86 from the lamp 66, moisture can be removed.

As in Fig. 13, the wafer 90 may be exposed to the pulsed light 86 from below. Since the wafer 90 is heated by radiation from the pulsed light 86, the molecules 100 of water and the reaction product 102 evaporate. Further, the temperature of the boundary-air layer 74 rises to remove moisture from the wafer 90 and to prevent moisture from again adhering to the wafer 90. As in Fig. 13, a reflective board 69 may be provided outside the boundary-air layer 74 to face the wafer 90. The reflective board 69 reflects radiation from the wafer 90 to again expose it to the radiation so that the molecules 100 of water and the reaction product 102 evaporate and the boundary-air layer 74 is heated. Incidentally, apertures 67 are formed in the reflective board 69 to cause the clean air 72 to pass through them.

The present invention can be carried out in the following forms.

### Form 1

An apparatus for manufacturing semiconductors comprising:
processing equipment that processes a wafer;
a FOUP that supplies a wafer and that houses the wafer that has been processed, the FOUP being an airtight container for transporting wafers;
an EFEM that transfers the wafer between the FOUP and the processing equipment;
a fan and filter unit that sends an airflow from above to the EFEM; and
a lamp by which the wafer is exposed to light, the wafer being transported by the EFEM and having been processed.

### Form 2

The apparatus for manufacturing the semiconductors of Form 1, wherein the light is pulsed light.

### Form 3

The apparatus for manufacturing the semiconductors of Form 1 or 2, wherein the wafer is exposed to the light at two or more positions.

### Form 4

The apparatus for manufacturing the semiconductors of any of Forms 1 - 3, wherein the wafer is exposed to the light from the lamp that is located above the wafer.

### Form 5

The apparatus for manufacturing the semiconductors of any of Forms 1 - 3, wherein the wafer is exposed to the light from the lamp that is located below the wafer.

### Form 6

The apparatus for manufacturing the semiconductors of any of Forms 1 - 5, wherein the EFEM stops transportation of the wafer at a position where the wafer is exposed to the light.

### Form 7

The apparatus for manufacturing the semiconductors of any of Forms 1 - 6, wherein the EFEM adjusts a height of the wafer where the wafer is exposed to the light.

### Form 8

The apparatus for manufacturing the semiconductors of any of Forms 1 - 7, wherein the wafer is heated from 80 °C to 200 °C by being exposed to the light.

As in Fig. 14, in the apparatus 1 for manufacturing the semiconductors the lamp 68 may be located at a position to expose the surface of the wafer 90 to the light, which surface is exposed to the ultrasonic waves 80. Further, the apparatus 1 for manufacturing the semiconductors may have equipment for rotating the wafer 90 such as a rotating table 96 for placing the wafer and a motor 98 for the rotating table, which surface is exposed to the ultrasonic waves 80. As discussed above, by rotating the rotating table 96 for placing the wafer to rotate the wafer 90 the molecules 100 of water that have been separated from the surface of the wafer 90 easily dissipate. Further, a small vibrator 54 may be used. The small vibrator 54 may be, for example, long and thin to cover an area with a specified width that extends a distance that equals the distance to the radius of the surface of the wafer 90. Namely, the maximum length (the horizontal length in Fig. 14) of the vibrator 54 may be less than the diameter of the wafer 90, so that the area of the vibrator 54 can be reduced. Further, a small lamp 68 may be used. The small lamp 68 may be, for example, long and thin to cover an area with a specified width that extends a distance that equals the distance to the radius of the surface of the wafer 90. Namely, the maximum length (the horizontal length in Fig. 14) of the lamp 68 may be less than the diameter of the wafer 90, so that the area of the vibrator 54 can be reduced. No illuminating angle of the lamp 68 needs to be widened.

Since the vibrator 54 and the lamp 68 as in Fig. 14 are used and the wafer 90 is rotated, the surface of the wafer 90 can be uniformly exposed to the ultrasonic waves 80 and to the pulsed light 88. Though the equipment for rotating the wafer 90 has been discussed as the rotating table 96 for placing the wafer and the motor 98 for the rotating table, a receiver of the wafer that is provided at the tip of the arm may be configured to rotate. Alternatively, the small vibrator 54 and the small lamp 68 as in Fig. 14 may be used by horizontally moving the table for placing the wafer, so that the entire surface of the wafer 90 is exposed to the ultrasonic waves 80 and to the pulsed light 88.

The vibrator 54 and the lamp 68 that are used in the present invention can be used for manufacturing a lithium-ion battery. Fig. 15 is a conceptual drawing that illustrates the configuration of a lithium-ion battery 150. The lithium-ion battery 150 has a configuration where a separator 160 is sandwiched between a positive electrode 154 and a negative electrode 158 to be rolled up in many layers. The positive electrode 154 is connected to a lead 152 and the negative electrode 158 is connected to a lead 156. A lithium salt that includes LiPF₆, LiBF₄, etc., is used for the separator 160. If moisture were to remain on the surface of the positive electrode 154, the negative electrode 158, or the separator 160, it would react with fluorine of LiPF₆, LiBF₄, etc., to generate hydrofluoric acid. The hydrofluoric acid would cause the insulating film to corrode. Then a short circuit between the electrodes would occur, to cause a fire. So, conventionally a lithium-ion battery has been manufactured in a dry room or a glove box. The processing environment has been controlled at a dew point of -50 °C - -40 °C. However, drying a dry room is costly. The operating space in a glove box is narrow, and so lowers the efficiency.

In this situation, as in Fig. 16, for example, an apparatus 170 for manufacturing lithium-ion batteries is equipped with the vibrator 54 that generates the ultrasonic waves 80 and the lamp 68 that emits the pulsed light 88. By the apparatus 170 for manufacturing lithium-ion batteries a sheet-like electrode 190 is conveyed by a conveying roller 172. An electrode 192 on which a separator 196 has been formed is wound over a winding roller 184 to be sent to a next process. Slurry 194 is applied by applying equipment 174 to the electrode 190 that is conveyed by the conveying roller 172. The slurry 194 is made by dissolving LiPF₆, LiBF₄, etc., in an organic solvent. Next, the slurry 194 that has been applied to the electrode 190 is dried by means of a dryer 176. The dryer 176 may be a known dryer, such as a hot-air blower and an electric heater. The slurry 194 that has been dried is pressed by a press 178 to form the separator 196. The separator 196 is inspected by inspecting equipment 180 to detect defects. It is preferable to mark by a marker 182 a part that has been judged as defective.

The ultrasonic waves 80 from the vibrator 54 of the ultrasonic generator 50 and the pulsed light 88 from the lamp 68 are applied to the surface of the electrode 190 just before the slurry 194 is applied to that surface, so that moisture is removed from the surface. Thus, no dry room or glove box is required, and so the cost can be reduced and the efficiency can be enhanced. Incidentally, the surface of the electrode 190 may be exposed only to the ultrasonic waves or only to the pulsed light. Alternatively, the ultrasonic generator 51 as in Fig. 7 may be used to expose the reverse surface of the electrode 192 to the ultrasonic waves. Or, as in Fig. 8, the ultrasonic generator 50 may be used to expose the top surface to the ultrasonic waves and the ultrasonic generator 51 may be used to expose the reverse surface to the ultrasonic waves. Further, as in Figs. 9 and 10, the position where the ultrasonic waves are applied may be the same as the position where the pulsed light is applied.

As in the above discussion, the separator 196 is formed on the electrode 190, such as the positive electrode 154, in the apparatus 170 for manufacturing lithium-ion batteries. However, the electrode, such as the negative electrode 158, may be formed on the electrode 192 on which the separator has been formed. In so doing, the ultrasonic generator 50, the lamp 68, etc., can be used to remove moisture on the surface of the electrode and to remove moisture on the separator.

Fig. 17 shows an example of the inner structure of the vibrators 54, 55. Fig. 17 is a structural drawing of the vibrators 54, 55, in which (a) is a sectional view in a section that is perpendicular to the direction of the vibration (for example, the vertical direction in Fig. 3) and (b) is a sectional view in a section that is perpendicular to that in (a) (for example, along the sheet in Fig. 3). (b) also shows the ultrasonic oscillator 52.

The vibrators 54, 55 as in Fig. 17 have multiple oscillators 200 and vibrating plates 202, 204 that are attached to both vertical ends of the oscillators 200. The oscillators 200 may each be made of a piezoelectric element that transduces an applied voltage to a force, namely, a displacement. When the oscillators 200 become large, they are easily damaged during their operation, especially during the operation in air. So, manufacturing the oscillators 200 so that they have a surface that corresponds to the surface of a wafer with a diameter of 300 mm is difficult. Thus, the multiple small oscillators 200 are sandwiched by the upper vibrating plate 202 and the lower vibrating plate 204 to form the vibrators 54, 55. The vibrating plates 202, 204 are made of a material that has high stiffness, such as metal and ceramic. Since the oscillators 200 are sandwiched by the pair of vibrating plates 202, 204, any possible damage to the oscillators 200 during their operation can be suppressed.

In the vibrators 54, 55 as in Fig. 17 the ultrasonic vibration that is generated by the oscillators 200 is transmitted to the upper vibrating plate 202 and the lower vibrating plate 204, to become uniform in them. Thus ultrasonic waves 80 that are uniform in a plane can be obtained. Further, any possible damage to the oscillators 200 during their operation can be prevented by being sandwiched by means of the upper vibrating plate 202 and the lower vibrating plate 204. A configuration that has five oscillators 200 is shown in Fig. 17, but the number of oscillators 200 is not necessarily limited. The diameter of each of the oscillators 200 is preferably, for example, 10 mm - 20 mm, so that manufacturing is facilitated and any possible damage during their operation can be prevented.

Fig. 18 shows an inner structure of the vibrators 54, 55 that differs from that of Fig. 17. Fig. 18 is a structural drawing of the vibrators 54, 55, in which (a) is a sectional view in a section that is perpendicular to the direction of the vibration (for example, the vertical direction in Fig. 3) and (b) is a sectional view in a section that is perpendicular to that in (a) (for example, along the sheet in Fig. 3). (b) also shows the ultrasonic oscillator 52.

The vibrators 54, 55 as in Fig. 18 have multiple oscillators 210, a lower vibrating plate 214 that is attached to an end (the lower end in Fig. 18) of each of the oscillators 210, an upper vibrating plate 212 that is disposed to be spaced apart from the other end of each of the oscillators 210 (above the upper end of each of the oscillators 210), and a side plate 216 that connects the upper vibrating plate 212 with the lower vibrating plate 214 to form a space that encloses the oscillators 210. Liquid 218 is filled in the space that is surrounded by the upper vibrating plate 212, the lower vibrating plate 214, and the side plate 216.

The oscillators 210 are similar to the oscillators 200 and may each be made of a piezoelectric element. The vibrating plates 212, 214 are also similar to the vibrating plates 202, 204. The side plate 216 is made of metal or ceramic like the vibrating plates 212, 214, but is not necessarily made of the same material as that of the vibrating plates 212, 214. The liquid 218 to be filled in the space is preferably one that has a high viscosity or a kinetic viscosity so as to suppress bubbles being generated by the ultrasonic waves 80 and so as to easily transmit ultrasonic vibrational energy to the upper vibrating plate 214. For example, a liquid of which the main component is dimethylpolysiloxane is used. The liquid that contains dimethylpolysiloxane as the main component has a high viscosity or a kinetic viscosity, is good in thermal stability and oxidative stability, has low vapor pressure, and is flame-retardant. Since the oscillators 210 operate in the space in which the liquid 218 is filled, any possible damage to the oscillators 200 during their operation can be suppressed.

By the vibrators 54, 55 as in Fig. 18 the ultrasonic vibrations that are generated by the oscillators 210 are transmitted to the upper vibrating plate 212 and the lower vibrating plate 214 through the filled liquid 218, to become uniform in planes. The ultrasonic waves 80 that are generated by the upper vibrating plate 212 reach the wafer 90 that is located above the vibrators 54, 55. Incidentally, the configuration of the vibrators 54, 55 is not necessarily limited to the above.

Below, the main reference numerals and symbols that are used in the detailed description and drawings are listed.
1, 2 the apparatus for manufacturing the semiconductors
10 the EFEM
12 the frame
14 the port for loading
16 the load-lock chamber
17 the table for placing the wafer
18 the robot
19 the arm
20 the fan and filter unit
22 the driving motor
24 the fan
26 the filter
30 the processing equipment
40 the FOUP (an airtight container for transporting wafers)
42 the door
50, 51 the ultrasonic generators
52 the ultrasonic oscillator
54, 55 the vibrators
56 the apertures
58, 59 the cables
60 the reflective board
62 the apertures
65 the pulsed-light generator
66, 68 the lamps
67 the apertures
69 the reflective board
70 the air that is in the clean room
72 the airflow of clean air
74 the boundary-air layer
80 the ultrasonic waves
82 the nodes of the standing waves
84 the antinodes of the standing waves
86, 88 the pulsed light
90 the wafer
96 the rotating table for placing the wafer (the equipment for rotation)
98 the motor for the rotating table for placing the wafer (the equipment
for rotation)
100 the molecules of water
102 the reaction product
150 the lithium-ion battery
152 the lead for the positive electrode
154 the positive electrode
156 the lead for the negative electrode
158 the negative electrode
160 the separator
170 the apparatus for manufacturing lithium-ion batteries
172 the conveying roller
174 the applying equipment
176 the dryer
178 the press
180 the inspecting equipment
182 the marker
184 the winding roller
190 the sheet-like electrode
192 the electrode on which a separator has been formed
194 the slurry
196 the separator
200, 210 the oscillators
202, 212 the (upper) vibrating plates
204, 214 the (lower) vibrating plates
216 the side plate of the vibrator
218 the liquid

## Claims

1. An apparatus (1, 2) for manufacturing semiconductors comprising:
processing equipment (30) configured to process a wafer (90);
a Front Opening Unified Pod, FOUP, (40) configured to:
- supply the wafer and
- house the wafer that has been processed;
an Equipment Front End Module, EFEM, (10) configured to transfer the wafer between the FOUP and the processing equipment;
a fan and filter unit (20) configured to send an airflow (72) from above to the EFEM;
the apparatus being **characterized in that** it further comprises an ultrasonic oscillator (52) configured to generate high-frequency power; and
a vibrator (54, 55) configured to:
- generate ultrasonic waves (80) by using the high-frequency power that is generated by the ultrasonic oscillator and
- apply the ultrasonic waves to the wafer that is transported in the EFEM and that has been processed,
wherein the ultrasonic oscillator is configured to:
- decrease the frequency of the ultrasonic waves from a specific frequency to another specific frequency for a predetermined period and
- increase it from the other specific frequency to the specific frequency for a period that is shorter than the predetermined period.

2. The apparatus for manufacturing semiconductors of claim 1 comprising:
multiple vibrators (54).

3. The apparatus for manufacturing semiconductors of claim 1 or 2, wherein the vibrator is configured to apply the ultrasonic waves from above the wafer.

4. The apparatus for manufacturing semiconductors of claim 1 or 2, wherein the wafer is placed on the vibrator and a reflective board (60) configured to reflect the ultrasonic waves is provided above the wafer in the EFEM.

5. The apparatus for manufacturing semiconductors of any of claims 1 to 4, wherein the EFEM is configured to stop transportation of the wafer at a position where the ultrasonic waves are applied to the wafer.

6. The apparatus for manufacturing semiconductors of any of claims 1 to 5, wherein the EFEM is configured to adjust a height of the wafer at a position where the ultrasonic waves are applied to the wafer.

7. The apparatus for manufacturing semiconductors of any of claims 1 to 6 further comprising:
a lamp (66) configured to expose the wafer to pulsed light (86).

8. The apparatus for manufacturing semiconductors of any of claims 1 to 7 further comprising:
equipment (96, 98) for rotation configured to rotate the wafer to which the ultrasonic waves are applied.

9. The apparatus for manufacturing semiconductors of claim 8 that depends on claim 7, wherein the lamp is located at a position to expose the surface of the wafer to the pulsed light, to which surface the ultrasonic waves are applied.

10. The apparatus for manufacturing the semiconductors of any of claims 1 to 9, wherein the vibrator has multiple oscillators (200, 210) that are formed of a piezoelectric element and a pair of vibrating plates (202, 204, 212, 214) that sandwich the multiple oscillators in a vibrating direction.

11. The apparatus for manufacturing semiconductors of any of claims 1 to 9, wherein the vibrator has multiple oscillators (210) that are formed of a piezoelectric element, a vibrating plate (214) that is attached to an end of each of the multiple oscillators in a vibrating direction, a vibrating plate (212) that is spaced apart from the other end of each of the multiple oscillators in the vibrating direction, a side plate (216) that connects two vibrating plates to form a space that encloses the multiple oscillators, and a liquid (218) that is filled in the space.

## Patentansprüche

1. Vorrichtung (1, 2) zur Herstellung von Halbleitern, die umfasst:
eine Verarbeitungsanlage (30), die konfiguriert ist, um einen Wafer (90) zu verarbeiten;
einen Front Opening Unified Pod, FOUP, (40), der konfiguriert ist, um:
- den Wafer zuzuführen und
- den Wafer, der verarbeitet wurde, zu beherbergen;
ein Equipment Front End Module, EFEM, (10), das konfiguriert ist, um den Wafer zwischen dem FOUP und der Verarbeitungsanlage zu transferieren;
eine Gebläse- und Filtereinheit (20), die konfiguriert ist, um einen Luftstrom (72) von oben zu dem EFEM zu schicken;
wobei die Vorrichtung **dadurch gekennzeichnet ist, dass** sie ferner umfasst:
einen Ultraschalloszillator (52), der konfiguriert ist, um Hochfrequenzleistung zu erzeugen; und
einen Vibrator (54, 55), der konfiguriert ist, um:
- Ultraschallwellen (80) zu erzeugen, indem die Hochfrequenzleistung genutzt wird, die von dem Ultraschalloszillator erzeugt ist, und
- die Ultraschallwellen an den verarbeiteten Wafer anzulegen, der in dem EFEM transportiert wird,
wobei der Ultraschalloszillator konfiguriert ist, um:
- die Frequenz der Ultraschallwellen für eine vorbestimmte Zeitspanne von einer spezifischen Frequenz auf eine andere spezifische Frequenz zu senken, und
- von der anderen spezifischen Frequenz auf die spezifische Frequenz für eine Zeitspanne erhöhen, die kürzer als die vorbestimmte Zeitspanne ist.

2. Vorrichtung zur Herstellung von Halbleitern nach Anspruch 1, die umfasst:
eine Vielzahl von Vibratoren (54).

3. Vorrichtung zur Herstellung von Halbleitern nach Anspruch 1 oder 2, wobei der Vibrator konfiguriert ist, um die Ultraschallwellen von oberhalb des Wafers anzulegen.

4. Vorrichtung zur Herstellung von Halbleitern nach Anspruch 1 oder 2, wobei der Wafer auf dem Vibrator angeordnet wird und eine reflektierende Platte (60), die konfiguriert ist, um die Ultraschallwellen zu reflektieren, oberhalb des Wafers in dem

5. Vorrichtung zur Herstellung von Halbleitern nach einem der Ansprüche 1 bis 4, wobei das EFEM konfiguriert ist, um den Transport des Wafers bei einer Position anzuhalten, an der die Ultraschallwellen an den Wafer angelegt werden.

6. Vorrichtung zur Herstellung von Halbleitern nach einem der Ansprüche 1 bis 5, wobei das EFEM konfiguriert ist, um eine Höhe des Wafers bei einer Position einzustellen, an der die Ultraschallwellen an den Wafer angelegt werden.

7. Vorrichtung zur Herstellung von Halbleitern nach einem der Ansprüche 1 bis 6, die ferner umfasst:
eine Lampe (66), die konfiguriert ist, um den Wafer gepulstem Licht (86) auszusetzen.

8. Vorrichtung zur Herstellung von Halbleitern nach einem der Ansprüche 1 bis 7 die ferner umfasst:
eine Ausrüstung (96, 98) zur Drehung, die konfiguriert ist, um den Wafer, an den die Ultraschallwellen angelegt werden, zu drehen.

9. Vorrichtung zur Herstellung von Halbleitern nach Anspruch 8, der von Anspruch 7 abhängt, wobei die Lampe bei einer Position angeordnet ist, um die Oberfläche des Wafers dem gepulsten Licht auszusetzen, an dessen Oberfläche die Ultraschallwellen angelegt werden.

10. Vorrichtung zur Herstellung von Halbleitern nach einem der Ansprüche 1 bis 9, wobei der Vibrator eine Vielzahl von Oszillatoren (200, 210) aufweist, die aus einem piezoelektrischen Element und einem Paar von Vibrationsplatten (202, 204, 212, 214) gebildet sind, die die Vielzahl von Oszillatoren in einer Vibrationsrichtung sandwichartig zwischen sich einschließen.

11. Vorrichtung zur Herstellung von Halbleitern nach einem der Ansprüche 1 bis 9, wobei der Vibrator eine Vielzahl von Oszillatoren (210) aufweist, die aus einem piezoelektrischen Element, einer Vibrationsplatte (214), die an einem Ende jedes der Vielzahl von Oszillatoren in einer Vibrationsrichtung angebracht ist, einer Vibrationsplatte (212), die von dem anderen Ende jedes der Vielzahl von Oszillatoren in der Vibrationsrichtung beabstandet ist, einer Seitenplatte (216), die zwei Vibrationsplatten verbindet, um einen Raum zu bilden, der die Vielzahl von Oszillatoren einschließt, und einer Flüssigkeit (218), die in den Raum gefüllt ist, gebildet sind.

## Revendications

1. Appareil (1, 2) de fabrication de semi-conducteurs comprenant :
un équipement de traitement (30) conçu pour traiter une plaquette (90) ;
une nacelle unifiée à ouverture frontale, FOUP, (40) conçue pour :
- fournir la plaquette et
- loger la plaquette qui a été traitée ;
un module frontal d'équipement, EFEM, (10) conçu pour transférer la plaquette entre la FOUP et l'équipement de traitement ;
une unité de ventilateur et de filtre (20) conçue pour envoyer un flux d'air (72) depuis le dessus vers l'EFEM ;
l'appareil étant **caractérisé en ce qu'**il comprend en outre un oscillateur à ultrasons (52) conçu pour générer une puissance haute fréquence ; et
un vibrateur (54, 55) conçu pour :
- générer des ondes ultrasonores (80) en utilisant la puissance haute fréquence qui est générée par l'oscillateur à ultrasons et
- appliquer les ondes ultrasonores à la plaquette qui est transportée dans l'EFEM et qui a été traitée,
dans lequel l'oscillateur à ultrasons est conçu pour :
- diminuer la fréquence des ondes ultrasonores d'une fréquence spécifique à une autre fréquence spécifique pendant une période prédéterminée et
- l'augmenter de l'autre fréquence spécifique à la fréquence spécifique pendant une période qui est plus courte que la période prédéterminée.

2. Appareil de fabrication de semi-conducteurs selon la revendication 1 comprenant :
de multiples vibrateurs (54).

3. Appareil de fabrication de semi-conducteurs selon la revendication 1 ou 2, dans lequel le vibrateur est conçu pour appliquer les ondes ultrasonores depuis le dessus de la plaquette.

4. Appareil de fabrication de semi-conducteurs selon la revendication 1 ou 2, dans lequel la plaquette est placée sur le vibrateur et une plaque réfléchissante (60) conçue pour réfléchir les ondes ultrasonores est prévue au-dessus de la plaquette dans l'EFEM.

5. Appareil de fabrication de semi-conducteurs selon l'une quelconque des revendications 1 à 4, dans lequel l'EFEM est conçu pour arrêter le transport de la plaquette à une position où les ondes ultrasonores sont appliquées à la plaquette.

6. Appareil de fabrication de semi-conducteurs selon l'une quelconque des revendications 1 à 5, dans lequel l'EFEM est conçu pour ajuster une hauteur de la plaquette à une position où les ondes ultrasonores sont appliquées à la plaquette.

7. Appareil de fabrication de semi-conducteurs selon l'une quelconque des revendications 1 à 6, comprenant en outre :
une lampe (66) conçue pour exposer la plaquette à une lumière pulsée (86).

8. Appareil de fabrication de semi-conducteurs selon l'une quelconque des revendications 1 à 7, comprenant en outre :
un équipement (96, 98) de rotation conçu pour faire tourner la plaquette à laquelle sont appliquées les ondes ultrasonores.

9. Appareil de fabrication de semi-conducteurs selon la revendication 8 qui dépend de la revendication 7, dans lequel la lampe est située à une position pour exposer à la lumière pulsée la surface de la plaquette, à laquelle sont appliquées les ondes ultrasonores.

10. Appareil de fabrication de semi-conducteurs selon l'une quelconque des revendications 1 à 9, dans lequel le vibrateur a de multiples oscillateurs (200, 210) qui sont formés d'un élément piézoélectrique et une paire de plaques vibrantes (202, 204, 212, 214) qui prennent en sandwich les multiples oscillateurs dans une direction de vibration.

11. Appareil de fabrication de semi-conducteurs selon l'une quelconque des revendications 1 à 9, dans lequel le vibrateur a de multiples oscillateurs (210) qui sont formés d'un élément piézoélectrique, une plaque vibrante (214) qui est fixée à une extrémité de chacun des multiples oscillateurs dans une direction de vibration, une plaque vibrante (212) qui est espacée de l'autre extrémité de chacun des multiples oscillateurs dans la direction de vibration, une plaque latérale (216) qui relie deux plaques vibrantes pour former un espace qui renferme les multiples oscillateurs, et un liquide (218) qui est introduit dans l'espace.
